# EUROPEAN PATENT SPECIFICATION

(11) **EP 2 376 681 B1**
(45) Date of publication and mention of the grant of the patent: **11.06.2014**
(21) Application number: 09832329.8
(22) Date of filing: 24.11.2009
(51) Int. Cl.: C30B 25/14, C30B 29/04, C30B 25/10

(54) **PRODUCTION OF SINGLE CRYSTAL CVD DIAMOND RAPID GROWTH RATE**
ERZEUGUNG EINES EINKRISTALLDIAMANTS MITTELS CVD MIT SCHNELLER WACHSTUMSRATE
PRODUCTION DE DIAMANT MONOCRISTALLIN PAR DÉPÔT EN PHASE VAPEUR À VITESSE DE CROISSANCE RAPIDE

(30) Priority: 25.11.2008 US 117793 P
(43) Date of publication of application: 19.10.2011
(73) Proprietor: Carnegie Institution Of Washington, Washington, DC 20005 (US)
(72) Inventor: YAN, Chih-Shiue, Washington, DC 20015 (US); MAO, Ho-Kwang, Washington, DC 20015 (US); HEMLEY, Russell, Washington, DC 20015 (US); LIANG, Qi, Washington, DC 20015 (US); MENG, Yufei, Washington DC 20015 (US)
(74) Representative: Lipscombe, Martin John
(86) International application number: PCT/US2009/065657
(87) International publication number: WO 2010/068419

(56) References cited:
- WO-A2-2006/127611
- WO-A2-2007/059251
- WO-A2-2007/092893
- US-A- 5 628 824
- US-A- 5 961 717
- US-A1- 2007 196 263
- CHIH-SHIUE YAN ET AL.: 'Very high growth rate chemical vapor deposition of single-crystal diamond' PROC. NATL. ACAD. SCI. U.S.A. vol. 99, 2002, pages 12523 - 12525, XP002572740
- A. CHAYAHARA ET AL.: 'The effect of nitrogen addition during high-rate homoepitaxial growth rate of diamond by microwave plasma CVD' DIAMOND & RELATED MATERIALS vol. 13, 2004, pages 1954 - 1958, XP004614810

## Description

### Background of the Invention

### Field of the Invention

The present invention relates to a method for producing a single crystal diamond at a high growth rate using Microwave Plasma Chemical Vapor Deposition (MPCVD).

### Description of Related Art

Large-scale production of synthetic diamond has long been an objective of >both research and industry. Diamond, in addition to its gem properties, is the hardest known material, has the highest known thermal conductivity, and is transparent to a wide variety of electromagnetic radiation. These and other characteristics, therefore, make diamond very valuable industrially and open up a wide range of applications in a number of industries, in addition to its well-established value as a gemstone.

For at least the last twenty years, a process of producing small quantities of diamond by chemical vapor deposition (CVD) has been available. See B. V. Spitsyn et al., "Vapor Growth of Diamond on Diamond and Other Surfaces," Journal of Crystal Growth, Vol. 52, pp. 219-226. The process involves CVD of diamond on a substrate by using a combination of methane, or another simple hydrocarbon gas, and hydrogen gas at reduced pressures and temperatures of 800-1200° C. Hydrogen gas is included to prevent the formation of graphite as the diamond nucleates and grows. Growth rates of up to 1 µm/hour were reported with this technique.

Subsequent work, for example, that of Kamo et al. as reported in "Diamond Synthesis from Gas Phase in Microwave Plasma," Journal of Crystal Growth, vol. 62, pp. 642-644, has demonstrated the use of MPCVD to produce diamond at pressures of 1-8 kPa and temperatures of 800-1000° C with microwave power of 300-700 W at a frequency of 2.45 GHz. A concentration of 1-3 % methane gas was used in the process of Kamo et al. Maximum growth rates of 3 µm/hour were reported using this MPCVD process. In the above-described processes, and in a number of other reported processes, the growth rates are limited to only a few micrometers per hour.

Until recently, the known higher-growth rate processes only produced polycrystalline forms of diamonds. However, single crystal diamonds offer a variety of advantages over polycrystalline diamonds. Accordingly, considerable interest has been shown in recent years towards developing procedures which enable the fast growth of single-crystal CVD diamond by MPCVD.¹⁻⁴ It has been reported, for example, that nitrogen addition to MPCVD reaction chemistry (methane/hydrogen plasma) can significantly enhance the growth of {100} facets and produce smooth and continuous diamond surfaces.^{1,5} Yan et al.¹ originally reported high growth rates of up to 100 µm/hr, two orders of magnitude higher than standard processes for making CVD diamond at the time. Since then, efforts have been made to increase the growth rate³ or expand the growth area⁴ for single-crystal CVD diamond.

Plasma power density, which is directly associated with microwave power and operating pressure, has been acknowledged as the critical parameter for CVD diamond synthesis. However, because microwave power is normally regulated by the capacity of the microwave power supply, increasing the pressure appears to be the most likely way to increase the growth rate. Grotjohn et al.⁶ studied the relationship between power density and pressure up to 80 torr and show a near-linear trend. Chin et al⁷ reported an improvement in growth rate at near 300 torr growth pressure. However, in general, most research groups have focused on growth processes at pressures around 150 torr.^{4,8} The addition of nitrogen to the gas chemistry can enhance growth. However, this leads to diamond with a yellowish or light brown color due to broad UV-visible absorption.^{1,9} Meng et al.^{10,11} have reported that nitrogen-vacancy-hydrogen (NVH-) complex centers are associated with this coloration. The complex center concentration can be reduced by either high-pressure-high-temperature (HPHT) or low-pressure-high-temperature (LPHT) annealing.

Improved procedures for making single crystal diamonds using MPCVD are described and claimed in, for example, U.S. patents 7,883,684; 6,858,078 and 7,235,130. Further improvements are described and claimed in Application No. 11/438,260.

Notwithstanding the various efforts directed towards developing processes which might provide useful forms of single crystal CVD diamond, there remains a need to provide a process wherein CVD diamonds are prepared at a commercially attractive growth rate.

An important object of the invention is to provide such a process. Other objects will also be apparent from the following.

### Summary of the Invention

Broadly stated, the present invention provides an improvement in prior MPCVD procedures enabling the growth of single crystal CVD diamond as set forth in claim 1.

### Description of the Drawings

The invention is more fully described by reference to the accompanying drawings wherein:
Figure 1 shows OES intensities of CN, C₂, CH, H_{α} and diamond growth rates at various pressures;
Figure 2 shows the UV-visible absorption coefficient at room temperature (25°C) for brown, near-colorless and colorless CVD diamonds (SCD-1, SCD-2 and SCD-3, respectively), and for natural type-IIa diamond with a photograph insert of the three CVD diamond crystals; and
Figure 3 shows the photoluminescence (PL) spectra for natural type-IIa diamonds, light brown (SCD-1), near-colorless (SCD-2) and colorless single CVD diamonds (SCD-3).

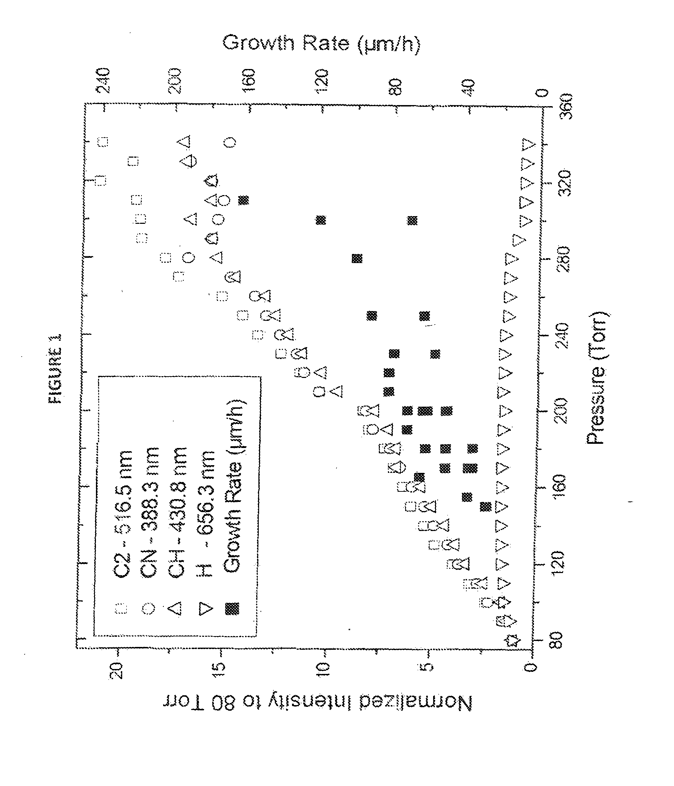

Referring more specifically to the drawings, it is noted that the OES intensities given in Figure 1 are normalized to measured values at 80 torr (1 torr = 133,3 Pa). Diamond growth rates were measured *ex-situ* by micrometer and then inserted into the plot.

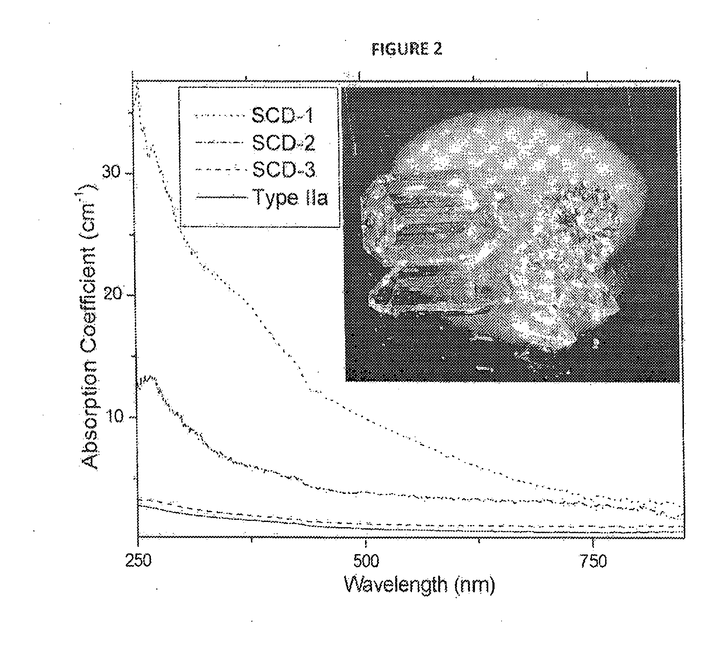

In Figure 2, the brown, near-colorless and colorless CVD diamonds are samples SCD-1, SCD-2 and SCD-3, respectively, referred to below. The insert is a photograph of the three single-crystal CVD diamond crystals SCD-1, SCD-2 and SCD-3 with energetic green plasma in the background. Clockwise from the top-right: 1) SCD-1: Light brown, brilliant cut and polished single crystal containing nitrogen (-0.5 carat); 2) SCD-2: Near colorless, 0.2 carat brilliant cut and polished single crystal produced from a -1 carat block; 3) SCD-3: Colorless 1.4 carat bullet shape single crystal produced from a -2.2 carat block.

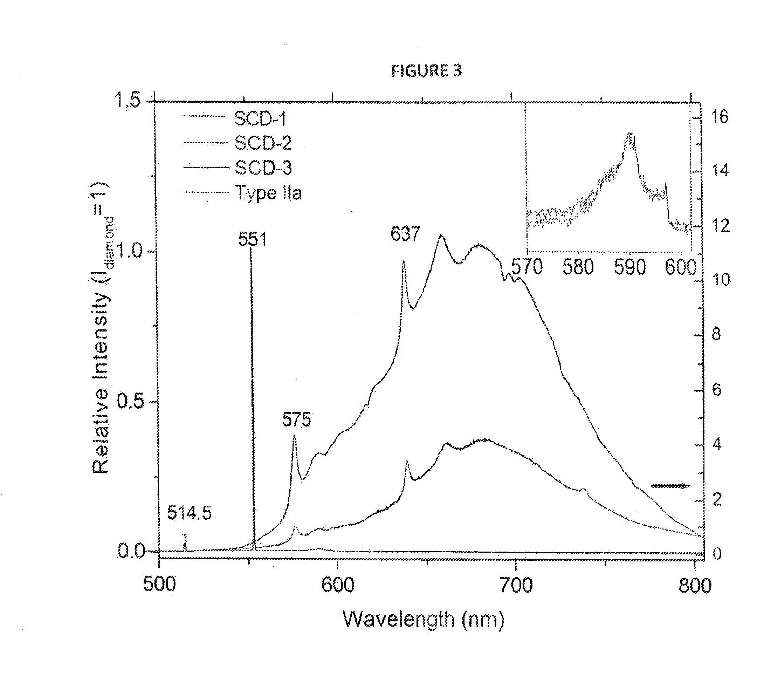

In Figure 3, the intensity scales were normalized to the diamond first order Raman peak. The insert provides detail of the 570-610 nm range for PL spectra (514.5 nm excitation, 300K).

It will be appreciated that the invention requires the use of a microwave plasma in an atmosphere comprising hydrogen, a carbon source such as methane or ethane, and oxygen. These are used in the ratios described in the aforementioned Appln. No. 11/438,260. It is also possible to include a small amount of nitrogen in the atmosphere but, if colorless diamonds are desired, the MPCVD process should be carried out in a nitrogen-free atmosphere. Other materials may also be included in the deposition atmosphere as noted elsewhere in this disclosure.

To maximize the diamond rate, it is preferred that the plasma density be in the range of about 10 watt/cm³ to about 10,000 watt/cm³ while the power source preferably is operated at 3000 to 5000 W. In one embodiment, the power source is operated at greater than 5 kW or higher. In another embodiment, the power source is operated at 15 kW or higher. In yet another embodiment, the power source is operated at 75 kW or higher. The plasma density should be maintained at the higher end of the indicated range when operating at above 400 torr. It is also critical when operating at pressures above 400 torr to take precautions to maintain the plasma stability and avoid arcing. Measures that can be taken to avoid arcing at pressures over 400 torr can include, for example, using a pulse microwave, operating in a divergent/multi-pole magnetic field, operating with additional components such as argon in the gas stream, and using a waveguide/storage/cavity design with different wavemodes (and then disturbing the modes). This latter measure can sustain a homogeneous stable plasma with a uniform temperature gradient.

Operating at higher powers and pressures enables an expansion of the deposition area. For example, the area can be expanded from about 1 inch (1 inch = 2,54 cm) in diameter when operating at 3 kW to around 3 inches in diameter when operating at higher power. This allows for the use of more than one seed per run, thus promoting mass production of single crystal diamonds.

It must be noted that at higher pressures, the plasma ball will become smaller, and higher power is necessary to sustain the size of the plasma. Additionally, it is advantageous to use the holder design with cooling capacity as described and claimed in previously referenced U.S. Patents 6,858,078 and 7,234,130.

As noted above, the process can be carried out at the desired pressure in the presence of a small amount of nitrogen (e.g. 0.2 to 3 parts nitrogen per 100 parts of carbon precursor). It has been found that by including nitrogen in the deposition atmosphere, growth rate can be increased by as much as three times the rate obtainable under otherwise similar conditions in the complete absence of nitrogen. The resulting CVD diamond has a brown color due to the presence of the nitrogen. This color can be removed by HTHP (high temperature high pressure) annealing of the diamonds. The brown color can be avoided so as to give colorless high quality diamonds at a somewhat lower growth rate by carrying out the CVD process in the absence of any added nitrogen, i.e. in an atmosphere consisting essentially of a carbon source, hydrogen and an oxygen source.

Typically the invention is used to prepare single crystal diamonds of varying dimensions. For, example, the product may be 1-2.5 karats in size. Typically, the diamond may be deposited to a thickness of 10-25 mm thickness, for example, a thickness of 18 mm. The deposition pressure can be varied over a relatively wide range, with 200-300 torr providing representative results. The example given herein utilizes pressure varying from 200 to 300 torr as illustrative, it being understood that the growth rate can be increased by increasing the pressure. For example, a growth rate of 165 µm/hr. can be obtained at 300 torr at high power density while an even higher rate can be realized at a pressure over 400 torr.

Various substrates can be used in the methods of the invention to prepare single crystal diamonds. For example, the substrate can be a natural diamond or a synthetic diamond, and further can be single crystal or polycrystalline. In certain embodiments the substrate can be, for example, a natural diamond (single crystal or polycrystalline), an HPHT diamond (single crystal or polycrystalline) or a CVD diamond (single crystal or polycrystalline). In preferred embodiments, the substrate can be a single crystal natural diamond, a single crystal HPHT diamond or a single crystal CVD diamond.

In certain embodiments of the invention, the crystal orientation of the substrate is 0-15 degrees off {100}. This is thought to increase the nucleation rate and reduce the level of impurities.

The gaseous atmosphere may comprise in lieu of oxygen or in addition to it other gases including, but not limited to, argon, CO, CO₂, boron hydride (B₂H₆), boron nitride or other boron-related material for nitrogen-free deposition. It must be noted that the source of oxygen in the gaseous atmosphere can be any compound which contains an oxygen atom but does not contain a nitrogen atom, including but not limited to O₂, CO₂, CO, water and ethanol.

As noted above, it is important to maintain an atmosphere which is essentially free of nitrogen. To that end, the methods of the present invention include measures to control the air leakage rate of the deposition chamber to below 0.003 mtorr/min. One such measure is to ensure that the atmosphere surrounding points in the system vulnerable to air leakage (e.g., vacuum connection parts such as viton gaskets) consists of a nitrogen-free gas (e.g., argon or CO₂). One means of accomplishing this is to surround the sealing area of vacuum parts with a balloon-type barrier material (e.g., a plastic) filled with a nitrogen-free gas. This will prevent air, which consists largely of nitrogen, from leaking into the sealing.

In order to generate a stable, symmetrical and centered plasma in the deposition chamber, it is important to evenly distribute the gas (e.g., H₂, CH₄, O₂) input and exhaust lines around the chamber. When the gas lines are evenly distributed around the chamber, the plasma will be located in the center of the chamber, as opposed to a location off-center (i.e., closer to the perimeter).

The following example shows that high quality brown, near colorless, and colorless single-crystal CVD diamond were grown at optimized condition, evaluated by optical omission spectroscope (OES) and characterized by photoluminescence and UV-visible absorption spectroscopy. The measurements obtained reveal a direct relationship between residual absorption and nitrogen content in the gas chemistry. The high growth rate and colorless single-crystal CVD diamond thus obtained with optical properties comparable to that of natural type-IIa diamond confirms the potential of the process and the resultant product. The fabrication of high quality single-crystal diamond at even higher growth rates are contemplated with modified reactor design that allows the use of higher gas synthesis pressures. Such modified reactor design includes means for avoiding arcing and the maintenance of a stable plasma density.

### Example

A 5kW, 2.45GHz ASTEX MPCVD system was used for single crystal diamond synthesis. HPHT synthetic type-Ib and single-crystal CVD diamond with {100} surfaces and minimum surface defects were used as substrates for diamond growth. A hydrogen generator with a palladium purifier was used to produce clean hydrogen with 7N purity. High purity methane (99.9995%) was also used.

Brown, near-colorless and colorless single-crystal CVD diamond were synthesized at 500 sccm H₂, 20 - 80 sccm CH₄, and 250 - 300 torr total pressure at temperatures ranging from 1000 °C to 1500 °C, with the microwave power ranging from 3000W to 5000W. As the diamond crystals became larger, a higher power/pressure combination was needed to heat up the diamond substrates and holder efficiently and maintain a stable ball-shaped plasma.² Details for these three samples can be found in Table 1.

**Table 1. Growth Details for Single Crystal Diamond**

| | Color | N₂/CH₄ | Pressure (torr) | Growth Rate (µm/h) | Weight, before laser cutting (carat) | Weight, after laser cutting (carat) |
|---|---|---|---|---|---|---|
| SCD-1 | Brown | 2% | 200-220 | 100-120 | 1.2 | 0.54 |
| SCD-2 | Near-colorless | 0.02% | 220-250 | 75-95 | 0.75 | 0.19 |
| SCD-3 | Colorless | 0% | 250-300 | 50-70 | 2.1 | 1.4 |

These three samples were laser cut and polished into gemstone shapes for further analysis.

One polished high grade natural type-IIa diamond was also used for comparison. UV-visible absorption spectra for these four samples are presented in Fig. 3, along with a photograph of the three single-crystal CVD diamonds used in this example. Nitrogen-doped single-crystal CVD diamond exhibits features typical of brown CVD diamond, including broad bands at 270 nm (substitutional nitrogen), and 370 nm and 550 nm (nitrogen vacancy center).¹¹ It is clear that the higher nitrogen content in the growth chemistry leads to a higher background in the UV-visible spectra, which implies that defect centers and dislocations induced by nitrogen addition can dramatically affect the color of diamond. With lower nitrogen content in the gas chemistry, the UV-visible line shape becomes more even and the intensities of nitrogen-related bands decreases. There is no significant difference in the Raman lineshape of SCD-3 and the type-IIa natural diamond. The absorption coefficient of SCD-3 is slightly higher, very likely due to nitrogen impurities within the methane gas used for the growth. However, the relative contribution to the residual color and broad spectral features due to point and extended defects induced by growth in the presence of nitrogen were not determined.¹⁰

Optical emission spectra (OES) were recorded with an Ocean Optics spectrometer with a 3 mm diameter optical fiber. PL spectra were excited with an argon ion laser at 514.5 nm. The optical properties of these materials were further investigated by micro UV-visible absorption spectroscopy. A Q-switched YAG laser system was used to remove growth layers from diamond substrates.

OES is a useful tool for the characterization of CVD diamond growth.¹²⁻¹⁵ It has been reported that the emission spectra of H₂/CH₄/N₂ plasmas are dominated by the C₂ (d³Π_{g}→a³Πᵤ) Swan band system, together with atomic hydrogen emission (Balmer-α transition, H_{α}) at 656.3 nm, the CN (B²Σ+→X²Σ⁺) system at around 388 nm, and a relatively weak yet detectable emission of CH (A²Δ→X²Π) at wavelengths of - 431.5 nm.^{12,13} Fig. 1 shows the measured variation of CN, C₂, CH, and H_{α} with pressure ranging from 80 torr to 350 torr, with 10 torr increments. H₂, CH₄, and N₂ flow rates were fixed at 500, 50, and 10 sccm, respectively. Microwave power was fixed at 3000 W, and the diamond substrate temperature ranged from 1100°C to 1300°C. To better understand data evolution, emission intensities for all bands were normalized by measured values at 80 torr. Single-crystal CVD diamond have been synthesized at selected pressures.

Visually, the plasma ball significantly shrank and became more intense with increasing pressure. The color of the plasma ball also turned from pale purple (dominated by emission of atomic hydrogen) to intensive green (emission dominated by C²) during the pressure increment. Growth of intensity from CN, C², and CH emissions, imply an increase in plasma density with increasing gas pressures. Growth rates also gradually increased with higher pressure, although a correlation between growth rate and detectable emission bands was not clear. The maximum growth rate of 165 µm/h was obtained at 310 torr, above which the growth rate stabilized and a long-lasting plasma ball was difficult to maintain without introducing a direct discharge between the microwave antenna and the substrate stage (i.e. arcing). It is interesting to note that H_{α} emission showed a negligible variation throughout the measurement. Several models have been constructed to explain the correlation between the presence of atomic hydrogen and diamond growth rates.^{6,14} Atomic hydrogen can etch away the undesired sp² phase and help attach hydrocarbon species to the diamond substrate by means of C-H and H-H bonds. The OES observations in this study, however, reveal that, at pressures higher than 150 torr, with the concentration of atomic hydrogen remaining almost constant, the growth rate continued to increase as the pressure went up. On the other hand, it is important to note that up until very recently, most theoretical studies of diamond growth focused on low pressure processes (<150 torr), with low CH₄/H₂ feed gas ratios (<2%). There is a lack of studies describing the modeling of growth mechanisms at pressures higher than 150 torr. One possible explanation is that CH₃, another key species in diamond growth, is not detectable by the OES employed in this study.^{15,16} From the general trend of carbon related species in the measurements taken, it is proposed that the CH₃ molecular density also increased considerably based on the significant increase in plasma density. This might explain the highly increased growth rate. This view is supported by theoretical calculations, which show a continuous increase of growth rate up to 200 torr.¹⁶ It is worth noting that changes in emission intensities may not directly represent the density of individual species, and more detailed experimental and modeling work would be required to interpret the growth processes at even higher pressures.

Photoluminescence spectra measured for nitrogen-doped single-crystal CVD diamond show signatures of obvious nitrogen-vacancy centers at 575 (NV⁰) and 637 (NV-) nm, along with a broad luminescence background. Similar to what we observed in the UV-visible absorption spectra, the decrease in nitrogen content in the gas chemistry leads to a decrease in the intensities of detectable NV centers, which finally diminish for sample SCD-3. For sample SCD-2, silicon related defects at 735 nm were also detected, and can be attributed to the quartz windows exposed to high heat inside the CVD chamber.¹⁷ The natural type-IIa diamond had a negligible background with the prominent feature being the first-order diamond Raman peak. The second-order Raman feature between 575 and 600 nm was also observed for the type-IIa diamond. SCD-3 grown without nitrogen addition exhibited similar PL spectra to the IIa diamond. It is difficult to distinguish SCD-3 from high quality type-IIa diamond based on these spectra.

For natural brown IIa diamond, the color is normally considered to be the consequence of extensive plastic deformation, ^{18,19} and type-Ia diamond with high nitrogen content (> 100 ppm) can be found either brown or colorless. This indicates that nitrogen might not be a direct factor in determining diamond color. However, it is clear that the amount of nitrogen content in the growth chemistry directly determines the number of nitrogen induced defects and impurities, and consequently the diamond visible absorption. The nitrogen content in high growth rate CVD diamond is generally very low (<10 ppm) (i.e., in the range of natural type-IIa diamond).²⁰ Meng et al.¹⁰ correlated the evolution of visible absorption in diamond with the nitrogen-vacancy-hydrogen (NVH-) complex defects by means of low pressure high temperatures annealing. The present study indicates the decrease in nitrogen flow rate reduces the NVH- defect center concentration and improves the visible absorption in this type of diamond.

Based on the foregoing, it appears that increasing the growth pressure in excess of 400 torr, e.g. 410 torr, is effective to synthesize very large, high quality diamonds at still higher growth rates (e.g., 200 µm/h). The MPCVD reactor design is critical in this case as at higher pressure (e.g. 400 torr) direct arcing between the microwave antenna and substrate tend to occur. Such arcing is destructive for quartz components located in the path of microwave. Accordingly, as earlier indicated, the invention contemplates the use of means for preventing arcing and/or otherwise stabilizing the plasma when using relatively high pressure (greater than 400 torr). The importance of this has been demonstrated by an attempt to grow single-crystal CVD diamond at 1 atmosphere pressure using a reactor which was not designed to avoid arcing between the plasma and microwave antenna. However, deposition had to be cut short due to the instability of the plasma balls. It is, therefore, essential for the reactor to be capable of generating a stable plasma at chamber pressures in the 1-2 atmosphere range.

While the method of the invention has been illustrated above using a pressure of 300 torr, it is considered on the basis of the results obtained that increasing the pressure to above 400 torr, e.g. 410-425 torr, up to atmospheric pressure, the growth rate of CVD diamond can be increased on an essentially linear basis. To do this, it is important to provide a furnace and associated means that avoid arcing and provide a stable plasma.

As indicated above, the use of a limited amount of nitrogen, in combination with oxygen, is considered to be advantageous towards increasing the growth rate although this results in diamonds of a brownish color which can be eliminated by subsequent annealing. Colorless diamonds are obtained if the presence of nitrogen is avoided or kept to a minimum as aforesaid.

The foregoing description, using 300 torr pressure to grow high quality single crystal CVD diamond at a rate of 165 µm/h is given only to demonstrate that growth rate can be increased dramatically by increasing the deposition pressure. OES measurement confirm a relationship between plasma density and growth rate, namely, that increased plasma density resulting from increased pressure, increases the growth rate. It appears that atomic hydrogen, which has been considered critical to enhanced growth rates, is not the key factor towards enhancing growth rates at high synthesis pressure.

Photoluminescence and UV-visible absorption spectra reveal a general relationship between the brown color of diamond and nitrogen addition in the gas chemistry. The optical quality of colorless single-crystal diamond produced at high CVD pressure was found to be comparable to that of type-IIa natural diamond, as verified by PL and UV-visible spectroscopy.

Additional tests were successfully conducted for single crystal diamond synthesis using microwave power of 15 kW at 2.54GHz and 75 kW at 915 MHz. High power is necessary to generate a stable and large area plasma at higher pressure.

### List of References

1. C.S. Yan, Y.K. Vohra, H.K. Mao, and R.J. Hemley, Proc. Natl. Acad. Sci. U.S.A. 99, 12523 (2002).
2. R.J. Hemley, H.K. Mao, C.S. Yan and Y.K. Vohra, U.S. Patent No. 6,858,078 (22 February 2005).
3. O.A. Williams and R. Jackman, Diamond Relat. Mater. 13, 557 (2004).
4. J. Asmussen, T.A. Grotjohn, T. Schuelke, M.F. Becker, M.K. Yaran, D.J. King, S. Wicklein, and D.K. Reinhard, Appl. Phys. Lett. 93, 1 (2008).
5. G.Z. Cao, J.J. Schermer, W.J.P. van Enckevort, W.A.L.M. Elst, and L.J. Giling, J. Appl. Phys. 79, 1357 (1996).
6. T. Grotjohn, R. Liske, K. Hassouni, and J. Asmussen, Diamond Relat. Mater. 14, 288 (2005).
7. C.Y. Chin, C.S. Yan, J. Lai and R.J. Hemley, Carnegie Summer Symposium, August (2006).
8. Y. Kokuno, A. Chayahara, Y. Soda, Y. Horino and N. Fujimori, Diamond Relat. Mater. 14, 1743 (2005).
9. S.S. Ho, C.S. Yan, Z. Liu, H.K. Mao and R.J. Hemley, Industrial Diamond Rev. 1, 28 (2006).
10. Y.F. Meng, C.S. Yan, J. Lai, S. Krasnicki, H.Y. Shu, T. Yu, Q. Liang, H.K. Mao, R.J. Hemley, Proc. Natl. Acad. Sci. U.S.A. In Press (2008).
11. S.C. Charles et al., Phys. Stat. Sol. (a), 11, 2473 (2004).
12. J.A. Smith, K.N. Rosser, H. Yagi, M.I. Wallace, P.W. May, and M.N.R. Ashfold, Diamond Relat. Mater. 10, 370 (2001).
13. Y. Liao, C.H. Li, Z.Y. Ye, C. Chang, G.Z. Wang, and R.C. Fang, Diamond Relat. Mater. 9, 1716 (2000).
14. T.P. Mollart and K.L. Lewis, Diamond Relat. Mater. 8, 236 (1999).
15. E. Kondoh, T. Ohta, T. Mitomo, and K. Ohtsuka, J. Appl. Phys. 73, 3041 (1993).
16. Y.A. Mankelevich and P.W. May, Diamond Relat. Mater. 17, 1021 (2008).
17. M. Fauchet and I.H. Campbell, Crit. Rev. Solid State Mater. Sci. 14, S79-101 (1988).
18. L.S. Hounsome, R. Jones, P.M. Martineau, D. Fischer, M.J. Shaw, P.R. Briddon and S. Oberg, Phys. Rev. B 73, 125203 (2006).
19. H.K. Mao and R.J. Hemley, Nature, 351, 721 (1991).
20. Q. Liang, Y.F. Meng, C.S. Yan, J. Lai, S. Krasnicki, H.K. Mao, R.J. Hemley, Diamond Relat. Mater 18, 698 (2009).

It will be recognized that various modifications may be made in the invention described herein. Accordingly, the scope of the invention is defined in the following claims wherein:

## Claims

1. In a method of producing single crystal diamonds by microwave plasma-assisted chemical vapor deposition which comprises providing a substrate and establishing a microwave plasma ball in an atmosphere comprising hydrogen, a carbon source and an oxygen source at a pressure and temperature sufficient to cause the deposition of diamond on said substrate, the improvement wherein the diamond is deposited under a pressure in the range 26.67-40.00 KPa (200-300 torr) at a growth rate in the range 50-120 µm/hr. from an atmosphere which is free of nitrogen, or which includes a small amount of nitrogen from 0.2 to 3 parts nitrogen per 100 parts of carbon, and wherein the atmosphere is contained within a deposition chamber, and gas input and exhaust lines are evenly distributed around the chamber, such that the plasma is located in the centre of the chamber.

2. The method of claim 1 wherein the diamond produced has a brown color and the diamond is subjected to an annealing process to remove the brown color.

3. The method of claim 1 wherein the temperature is in the range of about 1000°C to about 1500 °C.

4. The method of claim 1 wherein plasma density is in the range of about 10 watts/cm³ to about 10,000 watts/cm³.

5. The method of claim 1 wherein diamond is deposited using a power source of 3000 to 5000 W.

6. The method of claim 1 wherein diamond is deposited using a power source of greater than 5000 W.

7. The method of claim 6 wherein diamond is deposited using a power source of greater than 15 kW.

8. The method of claim 7 wherein diamond is deposited using a power source of greater than 75 kW.

9. The method of claim 1 wherein the crystal orientation of the substrate is 0-15 degrees off {100}.

10. The method of claim 1, wherein the air leakage rate of the deposition chamber is controlled to below 0.003 mtorr/min.

## Patentansprüche

1. Verfahren zum Herstellen von Einkristalldiamanten durch eine von einem Mikrowellenplasma unterstützte chemische Gasphasenabscheidung, das ein Bereitstellen eines Substrats und ein Aufbauen einer Mikrowellenplasmakugel in einer Atmosphäre, die Wasserstoff, eine Kohlenstoffquelle und eine Sauerstoffquelle bei einem Druck und einer Temperatur, die ausreichend sind, um die Abscheidung eines Diamanten auf das Substrat zu veranlassen, aufweist, umfasst, wobei das Verfahren die Verbesserung liefert, bei der der Diamant unter einem Druck in dem Bereich 26,67 - 40,00 kPa (200-300 Torr) bei einer Wachstumsrate in dem Bereich von 50-120 µm/h aus einer Atmosphäre, die frei von Stickstoff ist oder die eine kleine Menge an Stickstoff von 0,2 bis 3 Teile Stickstoff pro 100 Teile Kohlenstoff enthält, abgeschieden wird, und wobei die Atmosphäre innerhalb einer Abscheidungskammer enthalten ist und wobei die Gaseinlass- und Gasauslassleitungen gleichmäßig um die Kammer verteilt sind, derart, dass das Plasma in dem Zentrum der Kammer angeordnet ist.

2. Verfahren nach Anspruch 1, wobei der produzierte Diamant eine braune Farbe aufweist und der Diamant einem Temperverfahren unterworfen wird, um die braune Farbe zu entfernen.

3. Verfahren nach Anspruch 1, wobei die Temperatur in dem Bereich von etwa 1.000 °C bis etwa 1.500 °C liegt.

4. Verfahren nach Anspruch 1, wobei die Plasmadichte in dem Bereich von etwa 10 Watt/cm³ bis etwa 10.000 Watt/cm³ liegt.

5. Verfahren nach Anspruch 1, wobei der Diamant unter Verwendung einer Leistungsquelle von 3.000 bis 5.000 W abgeschieden wird.

6. Verfahren nach Anspruch 1, wobei der Diamant unter Verwendung einer Leistungsquelle von größer als 5.000 W abgeschieden wird.

7. Verfahren nach Anspruch 6, wobei der Diamant unter Verwendung einer Leistungsquelle von größer als 15 kW abgeschieden wird.

8. Verfahren nach Anspruch 7, wobei der Diamant unter Verwendung einer Leistungsquelle von größer als 75 kW abgeschieden wird.

9. Verfahren nach Anspruch 1, wobei die Kristallorientierung des Substrats um 0-15 Grad von {100} abweicht.

10. Verfahren nach Anspruch 1, wobei die Luftleckrate der Abscheidungskammer gesteuert wird, um unterhalb von 0,003 mTorr/min zu sein.

## Revendications

1. Dans un procédé de production de diamants monocristallins par dépôt chimique en phase vapeur assisté par plasma micro-ondes qui comprend l'obtention d'un substrat et l'établissement d'une boule de plasma micro-ondes dans une atmosphère comprenant de l'hydrogène, une source de carbone et une source d'oxygène à une pression et une température suffisantes pour provoquer le dépôt de diamant sur ledit substrat, l'amélioration dans laquelle le diamant est déposé sous une pression dans la gamme de 26,67-40,0 kPa (200-300 torrs) à une vitesse de croissance dans la gamme de 150-120 µm/h, à partir d'une atmosphère qui est dépourvue d'azote, ou qui comporte une petite quantité d'azote de 0,2 à 3 parties d'azote pour 100 parties de carbone, et dans laquelle l'atmosphère est contenue à l'intérieur d'une chambre de dépôt, et des lignes d'admission et d'évacuation de gaz sont distribuées uniformément autour de la chambre, de telle sorte que le plasma est situé au centre de la chambre.

2. Procédé selon la revendication 1 dans lequel le diamant produit a une couleur brune et le diamant est soumis à un procédé de recuit pour retirer la couleur brune.

3. Procédé selon la revendication 1 dans lequel la température se situe dans la gamme d'environ 1000 °C à environ 1500 °C.

4. Procédé selon la revendication 1 dans lequel la densité du plasma se situe dans la gamme d'environ 10 watts/cm³ à environ 10 000 watts/cm³.

5. Procédé selon la revendication 1 dans lequel du diamant est déposé en utilisant une source d'alimentation de 3000 à 5000 W.

6. Procédé selon la revendication 1 dans lequel du diamant est déposé en utilisant une source d'alimentation de plus de 5000 W.

7. Procédé selon la revendication 6 dans lequel du diamant est déposé en utilisant une source d'alimentation de plus de 15 kW.

8. Procédé selon la revendication 7 dans lequel du diamant est déposé en utilisant une source d'alimentation de plus de 75 kW.

9. Procédé selon la revendication 1 dans lequel l'orientation cristalline du substrat est décalée de 0-15 degrés par rapport à {100}.

10. Procédé selon la revendication 1 dans lequel le taux de fuite d'air de la chambre de dépôt est contrôlé à moins de 0,003 mtorr/min.
